# NEUE EUROPÄISCHE PATENTSCHRIFT

(11) **EP 3 442 309 B2**
(45) Veröffentlichungstag und Bekanntmachung des Hinweises auf die Entscheidung über den Einspruch: **15.05.2024**
(45) Hinweis auf die Patenterteilung: 30.06.2021
(21) Anmeldenummer: 17185132.2
(22) Anmeldetag: 07.08.2017
(51) Int. Cl.: H05B 3/34, H05K 1/09

(54) **VERFAHREN ZUR HERSTELLUNG EINES ELEKTRISCH LEITFÄHIGEN TEXTILEN FLÄCHENELEMENTS**
METHOD FOR THE PRODUCTION OF AN ELECTRICALLY CONDUCTIVE TEXTILE SURFACE ELEMENT
PROCÉDÉ DE FABRICATION D'UN ÉLÉMENT TEXTILE PLAT CONDUCTEUR ÉLECTRIQUE

(43) Veröffentlichungstag der Anmeldung: 13.02.2019
(73) Patentinhaber: Benecke-Kaliko AG, 30419 Hannover (DE)
(72) Erfinder: Gerken, Andreas, 30161 Hannover (DE)
(74) Vertreter: Meissner Bolte Partnerschaft mbB

(56) Entgegenhaltungen:
- EP-B1- 2 457 944
- EP-B1- 2 457 944
- WO-A1-2008/060101
- WO-A1-2008/075915
- WO-A1-2008/075915
- WO-A1-2016/173726
- WO-A1-2016/173726
- JP-A- H03 237 799
- JP-A- 2003 266 612

## Beschreibung

Die Erfindung betrifft ein Verfahren zur Herstellung eines flexiblen textilen elektrisch leitfähigen Flächenelements.

Aus dem Stand der Technik ist eine Vielzahl von Möglichkeiten bekannt, elektrisch leitfähige Strukturen für resistive Heizungen, Sensoren, Schalter, Antennen, Sitzbelegungserkennungen etc. in ein flächiges Material insbesondere automobiles Dekormaterial einzubringen.

So sind Flächenheizelemente in vielfältigen Ausführungen bekannt. Beheizbare Oberflächen wie Sitzheizungen gehören heutzutage z. B. bei vielen Kraftfahrzeugen zur serienmäßigen Ausstattung. Dabei werden neben elektrischen Heizsystemen, die sich nicht in einem festen Verbund mit dem darüber liegenden Dekor- und Sitzfläche befinden, auch direkt beheizbare Materialien eingesetzt, die eine integrierte elektrische Heizfunktion besitzen. Als elektrische Widerstandsheizung lässt sich im Prinzip jedes Material verwenden, dass bei Stromdurchfluss einen elektrischen Widerstand besitzt, der zur Erwärmung dieses Materials führt. Verbreitet als Sitzheizungen sind nach wie vor Litzenheizungen, also in textiles Material, Leder oder Kunstleder eingebettete Heizdrähte, die anfällig für Brüche sind, relativ große unbeheizte Flächen zwischen den Litzen besitzen und sich hinsichtlich des elektrischen Widerstandes nicht verändern lassen.

Des Weiteren lassen sich auch elektrisch leitfähige Textilien als elektrische Widerstandsheizung nutzen. Solche Textilien mit elektrisch leitfähigen Fasern sind z.B. in der EP 1 835 786 A1, WO 2007/031324 A1, DE 42 33 118 A1, DE 41 10 36 425 A1, DE 10 2005 050 459 B3 oder DE 41 24 684 A1 beschrieben. Die Herstellung solcher Textilien ist in der Regel aufwändig und im Vergleich zu Standardtextilien, die in automobilen Kunstledern eingesetzt werden, sehr teuer, was einer Serien-Automobilproduktion entgegensteht.

Daneben gibt es weitere Konzepte, elektrisch leitfähige Strukturen mittels applizierbaren Heizlacken in flächige Dekormaterialien einzubringen. DE 10 2012 000 445 A1 offenbart eine Sitzheizung für ein Polster eines Fahrzeugsitzes mit wenigstens einem durch eine Steuerungseinrichtung ansteuerbaren und mit elektrischem Strom beaufschlagbaren Heizelement, wobei das Heizelement eine Heizschicht beispielsweise auf Basis von Carbo-Nanotubes aufweist, welche durch einen Heizlack gebildet ist. So sollen sich individuelle und bedarfsgerechte Heizelemente in Form und Größe erzeugen lassen. Damit lässt sich zwar die Geometrie der Heizelemente, nicht jedoch deren elektrischer Widerstand einstellen. Beschrieben wird auch, dass der Heizlack auf flexible Vliese oder Gewebe aufgetragen werden kann. Bekanntermaßen ist es aber nachteilig, wenn ein Heizlack auf eine textile Struktur aufgetragen wird, da durch das Applizieren (in der Regel durch einen Rotations- oder Siebdruckprozess) der Heizlack zum Teil in die textile Struktur eindringt und so auf der bedruckten Oberfläche ein ungleichmäßiges Auftragsbild entsteht. Dadurch sind die Anforderungen an eine elektrische Flächenheizung, bei der die resistive Heizleistung von der Menge der aufgetragenen und leitfähigen Struktur abhängt, nicht erfüllbar, da bei Dünnstellen, beispielsweise durch Eindringen einer zu großen Menge Heizlack in die Textilstruktur, Hotspots entstehen können bzw. durch Unterbrechung der leitfähigen Struktur Kaltstellen. Auch wird hier nicht beschrieben, wie eine solche Struktur beispielsweise in einem Sitzpolster gegen äußere mechanische Einflüsse (z.B. durch dynamische Sitzbelastungen) oder Feuchtigkeit (verschüttete Flüssigkeiten, Schweiß, Kondenswasser) geschützt werden kann.

Die WO 2008/075915 offenbart einen beheizbaren Stoff für insbesondere militärische Kleidungsstücke, der aus einer textilen Basis-Schicht besteht, auf die eine leitfähige Schicht und zusätzlich eine heizbare Schicht/Heizschicht aufgebracht wird, sowie eine oberflächliche Isolierschicht. Die leitfähige Schicht und die Heizschicht können auf unterschiedliche Arten angeordnet sein, sind aber immer beide vorhanden.

Darüber hinaus ist eine zusätzliche glättende Schicht vorgesehen (primer layer 200), die für die Glättung des Textils vorgesehen ist und vermeiden soll, dass die leitfähigen Schichten in Hohlräume des Textils eindringen.

In der EP 2 457 944 B1 wird beschrieben, dass für eine optimale Beschichtungsqualität einer Heizpaste der zu bedruckende Untergrund möglichst glatt sein sollte, was bei Textilien durch eine flächige Beschichtung des Untergrundes erfolgen kann. Nachteilig ist hierbei, dass der Heizlack mit solchen Beschichtungssystemen chemische Wechselwirkungen aufweisen kann, so dass die elektrische Leitfähigkeit sich über die Zeit verändern kann (siehe Versuchsergebnisse). Zudem wird durch eine solche Beschichtung der textile Charakter wesentlich verändert und eine definierte reproduzierbare Beschichtung ist bei sehr leichten Textilien kaum möglich. In der gleichen Anmeldung wird auch beschrieben, dass die aufgebrachten leitfähigen Strukturen zum Schutz vor mechanischen, korrosiven oder Feuchtigkeitseinflüssen geschützt werden kann. Das kann beispielsweise durch eine zusätzliche Polymerschicht, Folie oder Textil geschehen. Dabei kann der notwendige zusätzliche Prozessschritt mit dem zusätzlich benötigten Abdeckmaterial als nachteilig empfunden werden. Weiterhin wird in der gleichen Anmeldung beschrieben, dass die elektrisch leitfähige Polymerschicht auf einen separaten textilen Träger oder Folie aufgebracht werden kann, welche dann separat oder in einem Verbund eingesetzt werden kann. Der Verbund kann dabei durch Kaschieren oder mechanische Methoden wie Vernähen, Vernieten, Klammern oder reversibel erfolgen.

Der Erfindung lag somit die Aufgabe zugrunde, ein Verfahren zur Herstellung eines flexiblen textilen elektrisch leitfähigen Flächenelements bereitzustellen, welches sich leicht herstellen lässt, eine gute Verbundhaftung zwischen elektrisch leitfähiger Schicht und textiler Trägerschicht und eine möglichst geringe Änderung der elektrischen Leitfähigkeit mit der Alterung, speziell unter

Grundsätzlich erfolgt die Lösung der Aufgabe dadurch, dass auf ein Gewebe, welches zuvor durch einen Kalanderprozess geglättet wurde, eine elektrische leitfähige Struktur beispielsweise zum Aufbringen elektrisch resistiver Heizstrukturen, kapazitiver Sensoren oder Antennen gedruckt wird. Das Bedrucken erfolgt vorteilhafterweise in einem Rotations-Siebdruckverfahren.

Die Aufgabe der vorliegenden Erfindung wird gelöst durch ein Verfahren zur Herstellung eines flexiblen textilen elektrisch leitfähigen Flächenelements nach Anspruch 1.

Dabei wird wenigstens eine Hauptfläche der textilen Trägerschicht vor dem Aufbringen der vernetzbaren Polymerdispersion gemäß Schritt b) so geglättet, dass nach dem Glätten einen Sz-Wert von 1,0 mm oder weniger aufweist, bestimmt nach DIN EN ISO 25178-2:2012, vorzugsweise von 0,5 mm oder weniger, wobei die vernetzbare Polymerdispersion unmittelbar auf die geglättete Oberfläche der textilen Trägerschicht aufgebracht wird.

Der Erfindung liegt die Erkenntnis zugrunde, dass durch die vorherige Glättung der textilen Trägerschicht und das unmittelbare Aufbringen einer vernetzbaren wässrigen Polymerdispersion enthaltend elektrisch leitfähige Partikel ein Schichtverbund erzeugt werden kann, dessen elektrische Leitfähigkeit kaum Alterungserscheinungen unterliegt, speziell bei Alterung unter erhöhten Temperaturen. Zudem lassen sich hohe Leitfähigkeiten mit vergleichsweise geringen Einsatzmengen an wässriger Polymerdispersion enthaltend elektrisch leitfähige Partikel erzielen, da durch das vorherige Glätten ein geringerer Anteil der Dispersion in die textile Trägerschicht einsinkt.

Als vernetzbare wässrige Polymerdispersionen enthaltend elektrisch leitfähige Partikel können beispielsweise solche eingesetzt werden, wie sie in der EP 2 457 944 B1 beschrieben sind. Grundsätzlich sind aber auch andere, dem Fachmann bekannte Dispersionen im Rahmen der vorliegenden Erfindung einsetzbar. Die Polymerdispersion enthaltend elektrisch leitfähige Partikel kann in beliebigen Mustern, wie Linien-, Kreuz-oder Rautenmuster, oder auch vollflächig aufgebracht werden.

Danach weist die textile Trägerschicht nach dem Glätten einen Sz-Wert von 1,0 mm oder weniger auf, bestimmt nach DIN EN ISO 25178-2:2012, vorzugsweise von 0,5 mm oder weniger. Dies ist besonders vorteilhaft, weil hierdurch eine geringere Auftragsmenge der Polymerdispersion enthaltend elektrisch leitfähige Partikel ausreicht, um die gewünschte Leitfähigkeit zu erzielen. Durch das Glätten vor dem Aufbringen der vernetzbaren wässrigen Polymerdispersion kann diese weniger in die Zwischenräume der Trägerschicht einsinken. Auf diese Weise ist es somit möglich, beispielsweise einen Kustlederschichtaufbau mit einer elektrisch leitfähigen Schicht, beispielsweise für einen Automobilsitz mit integrierter Sitzheizung herzustellen. Dieser Schichtaufbau ist insofern ungewöhnlich, als dass für Kunstlederschichtaufbauten in der Regel keine geglätteten, beispielsweise kalandrierten, textilen Trägerschichten verwendet werden.

Der Schritt des Glättens wird vorzugsweise in der Art und Weise ausgeführt, dass der Sz-Wert der textilen Trägerschicht, der ein Maß für die Rauigkeit des Gewebes ist, beim Glätten auf 80% des Sz-Wertes vor dem Glätten verringert wird, bestimmt nach DIN EN ISO 25178-2:2012, vorzugsweise auf 60 % oder weniger des Sz-Wertes vor dem Glätten.

Erfindungsgemäß erfolgt das Glätten der wenigstens einen Hauptfläche der textilen Trägerschicht in einem Kalander unter Erwärmung, wobei die Dicke der textilen Trägerschicht vorzugsweise um wenigstens 40% verringert wird. Typische Temperaturen für die Glättung in einem Kalander liegen im Bereich von 180 bis 230 °C, vorzugsweise von 190 bis 200 °C. Die vorgenannten Temperaturen gelten insbesondere für die erfindungsgemäß bevorzugten Trägerschichten aus Polyester, insbesondere
in Form von Polyestergeweben.

Alternativ aber nicht erfindungsgemäß hierzu erfolgt das Glätten der wenigstens einen Hauptfläche der textilen Trägerschicht durch Aufbringen eines thermoplastischen Polymers unter Erwärmung erfolgt, insbesondere mittels eines Kalanders. Das thermoplastische Polymer kann dabei ausgewählt sein aus Polyestern, Polyamiden, Polyolefinen, Polyurethanen, PVC, Polyacrylnitril, Polyvinylalkohol oder Copolymeren oder Mischungen von diesen.

Die im Rahmen des erfindungsgemäßen Verfahrens eingesetzte textile Trägerschicht kann beispielsweise ein Gelege, Gewirk, Gewebe oder einen Vlies umfassen oder daraus bestehen, wobei die textile Trägerschicht insbesondere ein Gewebe umfasst oder daraus besteht. Die textile Trägerschicht kann aus einem Material aufgebaut sein, das ausgewählt ist aus der Gruppe umfassend Polyester, Polyamiden, Polyolefinen, Polyurethanen, PVC, Aramide, Polyacrylnitril, Polyvinylalkohol, Poly(p-phenylen-2,6-benzobisoxazol) oder Copolymeren oder Mischungen von diesen. Die textile Trägerschicht kann ein Flächengewicht von 250 g/m² oder weniger aufweisen, insbesondere von 20 bis 150 g/m², bevorzugt 40 bis 100 g/m².

Es hat sich in Hinsicht auf die erzielbare Auftragsqualität der elektrisch leitfähigen Paste als besonders vorteilhaft erwiesen, wenn das zu bedruckende kalandrierte Gewebe aus Polyester (PET) besteht und ein Maximalgewicht von ca. 250 g/m², idealerweise aber ein Gewicht von ca. 40 - 100 g/m² aufweist. Die typischen Daten eines solchen kalandrierten Polyester-Textils sind wie folgt:
Gewicht: 80 g/m²
Dicke: ca. 100 µm
Reißkraft (EN ISO 13934-1): 300 N / 5 cm Kettrichtung, 500 N / 5 cm (Schussrichtung)
Reißdehnung (EN ISO 13934-1): 30 % Kettrichtung, 30 % (Schussrichtung)
Dehnung bei 10 N (EN ISO 13934-1): 0,5 % Kettrichtung, 0,5 % (Schussrichtung)
Dehnung bei 20 N (EN ISO 13934-1): 0,5 % Kettrichtung, 0,5 % (Schussrichtung)

Die leitfähigen Strukturen des so bedruckten Gewebes können besonders gut kontaktiert werden.

Die Aufbringung der vernetzbaren wässrigen Polymerdispersion enthaltend elektrisch leitfähige Partikel kann im Prinzip auf jede geeignete und dem Fachmann bekannte Weise erfolgen, beispielsweise durch Aufsprühen, Tauchen, Pinselauftrag oder durch Druckprozesse. Ganz bevorzugt erfolgt die Aufbringung der vernetzbaren wässrigen Polymerdispersion enthaltend elektrisch leitfähige Partikel über ein Siebdruckverfahren, insbesondere über ein Rotations-Siebdruckverfahren. Dieses Verfahren ist von Vorteil, weil hierdurch ein sehr gleichmäßiger und über die Prozessdauer sehr reproduzierbarer Auftrag erfolgen kann, sodass die beschichteten Gewebe eine möglichst geringe Schwankung bei der elektrischen Leitfähigkeit zeigen. Zudem kann bei Siebdruck und Rotations-Siebdruckverfahren die Auftragsmenge gering gehalten werden, was das Verfahren wirtschaftlicher gestaltet.

Wie vorstehend bereits dargelegt wurde, können für die Leitfähigkeitsbeschichtung im Prinzip alle dem Fachmann bekannten Dispersionen eingesetzt werden, vorzugsweise solche, wie sie in der EP 2 457 944 B1 beschrieben sind. Dabei sind vernetzbare wässrige Polymerdispersionen enthaltend ein Polyurethanpräpolymer besonders bevorzugt.

Als elektrisch leitfähige Partikel können beschichtete oder unbeschichtete Metallpartikel, beschichtete Glas-, Keramik-, Kunststoffpartikel oder Mischungen von diesen verwendet werden, um nur einige zu nennen. Besonders geeignet sind silberbeschichtete Kupferpartikel, da sich diese durch eine gute elektrische Leitfähigkeit, gute Korrosionsresistenz und einen akzeptablen Preis auszeichnen.

Nach dem Aushärten der Polymerdispersion zeichnet sich das nach dem erfindungsgemäßen Verfahren erzeugte Flächenelemente vorzugsweise durch eine laterale spezifische Leitfähigkeit von wenigstens 0,5 S/cm aus, vorzugsweise wenigstens 2,0 S/cm. Die Leitfähigkeit kann auf an sich bekannte Art über eine Widerstands- /Leitfähigkeitsmessung mit üblichen Messgeräten bestimmt werden.

Um für die spätere Nutzung des Flächenelementes eine einfachere Kontaktierung zu ermöglichen, kann erfindungsgemäß vorgesehen sein, dass an der elektrisch leitfähigen Schicht ein oder mehrere elektrische Kontakte angebracht werden. Eine Kontaktierung solcher erfindungsgemäßer Verbundmaterialien kann durch Crimpen oder Clinchen von elektrisch leitfähigen Leitern oder derart erfolgen, dass bei der Kaschierung lokal an definierten Stellen kein Kleberauftrag zwischen dem bedruckten Gewebe und dem Verbundmaterial erfolgt, so dass diese Stellen für eine spätere Kontaktierung zugänglich sind.

Eine weitere Möglichkeit der Kontaktierung besteht darin, dass bei der Kaschierung des bedruckten Gewebes ein thermoplastisches Klebematerial verwendet wird, so dass der Verbund an der zu kontaktierenden Stelle durch Erhitzen lokal gelöst werden kann und so diese Stelle für eine Kontaktierung zugänglich ist.

Das Flächenelement kann auf einer oder beiden Hauptflächen mit wenigstens einer weiteren Schicht teilweise oder vollständig beschichtet sein, insbesondere mit einer Deckschicht. Dies kann beispielsweise über einen Kaschierschritt auf an sich bekannte Weise erfolgen, beispielsweise mittels druck- oder thermisch aktivierbaren Klebstoffen, über thermoplastische Klebe-Webs, mit reaktiven ein- oder mehrkomponentigen bevorzugt lösungsmittelarmen oder -freien Klebstoffmassen, mit gelierenden polymeren Massen oder Klebstoffen auf Elastomerbasis. Die Kunststoffschicht kann also durch Kaschierung mit einem thermoplastischen Kleber, idealerweise mit thermoplastischem Klebeweb oder mit einem thermoplastischen Pulver erzeugt werden. Soll eine Luft- und Wasserdampfdurchlässigkeit erhalten bleiben, muss ein Textil oder offenporiger Schaum verwendet werden.

Die Schicht bzw. Schichten können als mechanischer Schutz oder Schutz gegen Feuchtigkeit oder Korrosion und der gleichen dienen oder aber auch der ästhetischen Gestaltung des Flächenelementes. So kann die Deckschicht eine Dekorschicht sein und insbesondere als kompakte oder geschäumte Kunststoffschicht vorliegen, die auf ihrer Oberseite mit einer Prägung versehen ist, insbesondere mit einer Narbenprägung.

Neben der Kaschierung mit dekorativen Verbundmaterialien kann auch eine flächige "Funktionmatte" dadurch hergestellt werden, dass das kalandrierte Gewebe nach dem Bedrucken mit der elektrisch leitfähigen Struktur bevorzugt mittels einer Flamm-, Kleber oder web-Kaschierung mit einem weichen Polyurethanschaum oder Vlies kaschiert wird. Dadurch erhält man ein elektrisch funktionales Flächengebilde, welches sich flexibel hinter beliebige Dekormaterialien wie Leder, Kunstleder, Folien, Textilien oder andere flächige Oberflächenmaterialien einbringen lässt.

In einer anderen Ausführungsform können die leitfähigen Strukturen nach Verbindung über die vorgenannten Kaschiermethoden außen liegen, wobei diese bevorzugterweise dann durch eine zusätzliche Kaschierung geschützt wird. Bevorzugt wird hier mittels einer Flamm-, web-Kaschierung oder Kaschierung mit einem anderen thermoplastischen Klebersystem ein weicher Polyurethanschaum aufgebracht. Aber auch andere Textilien, Vliese oder Folien können als Schutzschicht kaschiert werden. Eine Kaschierung über Klebstoffe auf wässriger Basis oder Lösungsmittelbasis ist auch hier wegen der negativen Wechselwirkungen und der Verschlechterung der elektrischen Leitfähigkeit nach Wärmebelastung zwar möglich aber nicht bevorzugt.

Nach einer bevorzugten Ausführungsform des erfindungsgemäßen Verfahrens wird die weitere Schicht nicht als wasser- oder lösemittelbasierte Schicht aufgebracht wird, sondern als kompakte Schicht beispielsweise aus einer Schmelze oder in Form einer Folie, die mit dem Schichtaufbau durch Aufschmelzen oder kleben verbunden wird. Dies ist deshalb von Vorteil da sich herausgestellt hat, dass die Aufbringung einer wasser- oder lösemittelbasierte Schicht auf die leitfähige Schicht zu einem Schichtverbund führt, bei dem die elektrische Leitfähigkeit zum Teil erheblichen Alterungsentscheidung unterliegt sodass bereits nach einer Woche Warmlagerung bei 90°C erhebliche Verluste bei der elektrischen Leitfähigkeit festzustellen sind.

Solcherart hergestellte elektrisch leitfähige Textilien können also auf der funktionalisierten Seite durch Kaschierung mit einem thermoplastischen Kleber wie z.B. einem Klebeweb mit einem zusätzlichen Textil, Folie oder Schaum kaschiert werden. Auch eine Flammkaschierung mit einem Polyurethanschaum ist möglich. Solche Verbundmaterialien sind dann flexibel hinter beliebigen Oberflächen (z.B. hinter Ledern, Kunstledern, Textilien oder anderen Oberflächenmaterialien) einsetzbar. Die funktionalisierten Textilien können aber auch als Trägertextil zu einem ein oder mehrlagigen Verbund kaschiert werden.

Erfolgt die Kaschierung so, dass wiederum ein thermoplastischer Kleber verwendet wird und die funktionalisierte Schicht im Verbund innen liegt, ist der erfindungsgemäße Verbund fertiggestellt kann aber noch weiter kaschiert werden, z.B. mit zusätzlichen Folien oder Schäumen.

Erfolgt die Kaschierung so, dass unter Verwendung eines beliebigen Kaschierklebers die funktionalisierte Schicht außen liegt, kann diese mittels eines thermoplastischen Klebers mit einem weiteren Textil, Folie oder Schaum kaschiert werden und ist dann geschützt. In beiden vorgenannten Fällen kann der zugrundeliegende Verbund auch ein schon vorhandenes Verbundgebilde sein, in dem schon mindestens eine textile Lage enthalten ist.

Im allgemeinen können die thermoplastischen Kleber als Folien, Pulver, Mikrogranulate, zuvor aufgeschmolzene thermoplastische Kleber (die dann beispielsweise mit einer Gravurwalze aufgedruckt werden) und bevorzugt als thermoplastische Klebewebs ausgeführt sein. Alle diese thermoplastischen Kleber können auch reaktiv sein wie z.B. feuchtigkeitsvernetzende reaktive Polyurethan-Hotmelt-Klebstoffsysteme,

Vorzugsweise erfolgt bei dem erfindungsgemäßen Verfahren das Aufbringen der vernetzbaren wässrigen Polymerdispersion enthaltend elektrisch leitfähige Partikel auf die geglättete Oberfläche der textilen Trägerschicht gemäß Schritt b) sowie optional das Aufbringen der wenigstens einen weiteren Schicht in einem Rolle-zu-Rolle Prozess. Dies ist von Vorteil, da diese Produktionsmethode eine schnelle und kostengünstige Herstellung erlaubt. Es ist aber auch möglich, das Flächenelement in einer Teilefertigung zu erzeugen, z.B. mit Siebdrucktischen oder Plattenpressen.

Ein weiterer offenbarter aber nicht erfindungsgemäßer Gegenstand betrifft ein flexibles textiles elektrisch leitfähiges Flächenelement, hergestellt nach einem erfindungsgemäßen Verfahren.

Die Erfindung ermöglicht somit die Darstellung von elektrisch funktionalisierten textilen Flächengebilden (z.B. zur integrierten Herstellung von resistiven Heizungen, Antennen, kapazitiven Schaltern und Reglern, Sitzbelegungserkennungen, Sensoren etc.), die sich flexibel hinter beliebigen Oberflächenmaterialien einsetzen lassen. Durch die textile Basis sind die Flächengebilde resistent gegen Dehnung während einer Herstellung im Rolle zu Rolle-Verfahren oder während der Verarbeitung und in der Anwendung aber gleichzeitig flexibel, insbesondere wenn dünne Textilien eingesetzt werden. Zusätzlich haben diese Verbundgebilde eine gute Durchlässigkeit für Luft und Wasserdampf, was bei Kaschierungen zu anderen Materialien wichtig ist oder auch bei Anwendungen im Sitzbereich für einen verbesserten Klimakomfort.

Mögliche Verwendungen des flexiblen textilen elektrisch leitfähigen Flächenelements als Sensor, elektrische Widerstandsheizung, Antenne, kapazitiven Schaltern und Reglern, zur elektromagnetischen Abschirmung, als elektrisch leitfähige Schicht oder Spur zur Verwendung oder zur Kontaktierung von elektronischen Bauteilen (wie LEDs, RFID-Chips, Kondensatoren, Mikroprozessoren etc.) auf flexiblen Untergründen
(wie Textilien, Folien, Kunstleder etc.); als elektrisch leitfähige Komponente in flexiblen Photovoltaikfolien; als elektrisch leitfähige Komponente in flexiblen (resistiven, induktiven oder kapazitiven) Displays, Schaltern, Reglem etc. ; als elektrisch leitfähige Komponente in flexiblen OLED-Anwendungen; zur Darstellung elektronischer Bauteile wie Kondensatoren auf einem flexiblen Untergrund; als elektrisch leitfähige Schicht in Drucktüchem, insbesondere für Drucktücher,
die für den Digitaldruck verwendet werden; als elektrisch leitfähige Komponente in einer Polymermatrix als Messfühler für eine mechanische Belastung, wodurch ein Rückschluss auf die Belastung bzw. Dehnung der umgebenden Matrix möglich ist (beispielsweise Flügel von Windrädern); als elektrisch leitfähige Komponente, um die dynamische Belastung von polymeren Bauteilen wie Keilriemen, Transportbänder oder Reifen durch direkten Kontakt oder elektromagnetische
Induktion zu verfolgen; als elektrisch leitfähige Komponente in Funktionsfolien, die heizen oder kühlen können; als flexible und dehnfähige Heizfolie im Bau- Wohn und Industriebereich; als flexible und dehnfähige Heizfolie im Bekleidungsbereich; zur Beheizung von Sportbekleidung oder Sportgeräten; als elektrisch leitfähige Komponente, um elektronische Bauteile gegen elektromagnetische Strahlung abzuschirmen und /oder zu beheizen; als elektrisch leitfähige flexible Komponente in flexiblen Sensoren oder Diagnosegeräten; als elektrisch leitfähige flexible Komponente in flexiblen
Batterien, insbesondere in Polster- und Sitzmöbeln, Sportgeräten, medizinischen Liegen, Sitzen oder Tischen, Fußböden, Wänden oder Wandbelägen, insbesondere Tapeten, werden ebenfalls beschrieben.

Die vorliegende Erfindung wird im Folgenden anhand von Ausführungsbeispielen näher erläutert.

### Beispiele

Eingesetzte Materialien:
Polyester-Futterlegung: Fa. Reichenbach Wirkstoff GmbH, Flächengewicht 130 g/m²,
Dicke ca. 500 µIM
PES-Gewebe: NEC Black, Fa. Lainiere de Picardie, Flächengewicht 47 g/m², Dicke 100 µm
Polyurethan-Polyester-Dispersion: Impranil DLP, Covestro Deutschland AG
Isocyanat-Vernetzer: Desmodur DN, Covestro Deutschland AG
Elektrischtrisch leitfähige Partikel: Conduct-O-Fil, SC500P18, Fa. Potters Industries Inc.

Bei den folgenden Beispielen und Vergleichsbeispielen handelt es sich um Kunststoffbeschichtete Dekormaterialien (Kunstleder), die als textilen Träger eine Polyester-Futterlegung (130 g/m², Dicke ca. 500 µm) bzw. ein PES-Gewebe (47 g/m²) enthalten, wobei letzteres zwischen zwei heißen Walzen kalandriert wurde, wodurch die Oberfläche des Textils weiter geglättet wurde. Durch das Kalandrieren wurde die ursprüngliche Dicke des Gewebes von ca. 200 auf ca. 100 µm reduziert.

Die PES-Futterlegung wird wegen ihrer Glattheit auch als Futterstoff für Anzüge verwendet, hinsichtlich der Glattheit wird dieses Textil jedoch von dem kalandrierten PES-Gewebe übertroffen. Die Glattheit wird bestimmt nach DIN EN ISO 25178-2:2012.

Druck außenliegend bedeutet hierbei, dass sich die aufgebrachte elektrisch leitfähige Beschichtung auf der äußeren Seite des Textilträgers befindet, Druck innenliegend bedeutet dementsprechend, dass er sich auf der inneren kaschierten Seite des Textilträgers befindet.
Probe 1: leitfähiger Druck auf PES-Futterlegung (130 g/m²), Druck außenliegend
Probe 2: leitfähiger Druck auf PES-Futterlegung (130 g/m²), Druck außenliegend, mit PUR-Dispersion als Schutz beschichtet
Probe 3: leitfähiger Druck auf PES-Futterlegung (130 g/m²), Druck innenliegend, mit PUR-Dispersion kaschiert
Probe 4: leitfähiger Druck auf PES-Futterlegung (130 g/m²), Druck innenliegend, mit Copolyester-web kaschiert
Probe 5: leitfähiger Druck auf PES-Gewebe (47 g/m²), Druck innenliegend, mit PUR-Dispersion kaschiert Probe
6: leitfähiger Druck auf PES-Gewebe (47 g/m²), Druck innenliegend, mit Copolyester-web kaschiert

### Prüfbedingungen:

Messung von DIN A5-Mustem, bedruckt mit Gitter (2 cm Gitterabstand), Dicke der Linien 2 mm, 60 g/m² Auftrag. Als elektrisch leitfähige Paste wurde eine Rezeptur auf Basis einer Rezeptur mit 44 Gew.-% der 50 Gew.-%igen wässrigen Polyurethan-Polyester-Dispersion (Impranil DLP), 55 Gew.-% elektrisch leitfähige Partikel und 1 Gew.-% Isocyanat-Vemetzer. Die Bestimmung der Stromstärke erfolgt bei 8 V angelegter Spannung:

| Probe | Konditionierung | Spannung [V] | Stromstärke [A] | Leistung bei 8V [W] |
|---|---|---|---|---|
| 1 a | ohne | 8 | 2,9 | 23,2 |
| 1 b | 7 d, 90 °C | 8 | 2,9 | 23,2 |
| 2 a | ohne | 8 | 2,9 | 23,2 |
| 2 b | 7 d, 90 °C | 8 | 0,7 | 5,6 |
| 3 a | ohne | 8 | 1,8 | 14,4 |
| 3 b | 7 d, 90 °C | 8 | 1,2 | 9,6 |
| 4 a | ohne | 8 | 2,8 | 22,4 |
| 4 b | 7 d, 90 °C | 8 | 2,8 | 22,4 |
| 5 a | ohne | 8 | 3,9 | 31,2 |
| 5 b | 7 d, 90 °C | 8 | 2,6 | 20,8 |
| 6 a | ohne | 8 | 4,3 | 34,4 |
| 6 b | 7 d, 90 °C | 8 | 4,3 | 34,4 |

Die Proben 1 a/1 b zeigen, dass die glatte Oberfläche der Polyester-Futterlegung nach Bedruckung mit der leitfähigen Paste eine gute Leitfähigkeit mit einer guten Wärmeleistung ergibt, die sich auch nach Alterung (7 Tage bei 90°C) nicht verändert. Wenn man jedoch versucht, diese elektrisch leitfähige Beschichtung vor mechanischen und/oder anderen Umwelteinflüssen durch eine Beschichtung mit einer wässrigen Polyurethandispersion zu schützen, erhält man zwar anfangs unverändert gute Leitfähigkeiten, die jedoch nach Wärmealterung (7 Tage 90°C) deutlich schlechter werden (Proben 2a/2b).

Auch der Versuch, die elektrische leitfähige Beschichtung durch eine Dispersionskaschierung zu schützen, so dass der elektrisch leitfähige Druck im Verbund innenliegend ist, zeigt nach Wärmelagerung ein negatives Ergebnis (Proben 3a/3b). Wenn man jedoch eine Kaschierung der mit elektrisch leitfähiger Paste bedruckten PES-Futterlegung vomimmt, wobei als Kaschiermedium ein thermoplastisches web verwendet wird (hierein Co-Polyester-Web "TecWel20" ABE001 der Fa. AB-Tec, welches eine Wärmestandfestigkeit von 105°C besitzt), gibt es keine negativen Wechselwirkungen zwischen der leitfähigen Beschichtung und dem Klebemedium, so dass die elektrische Leitfähigkeit nach Wär mealterung unverändert bleibt (Proben 4a/4b).

Ein ähnliches Ergebnis wie bei den Proben 3a/3b wird erzielt, wenn ein kalandriertes Polyester-Gewebe bedruckt wird und mit einer Dispersionskaschierung so mit einem anderen Flächengebilde verbunden wird, dass der elektrisch leitfähige Druck im Verbund innenliegend ist. So wird zuerst eine sehr gute Wärmeleistung erzielt, die allerdings nach einer Wärmelagerung deutlich abnimmt (Proben 5a/5b). Wird die vorgenannte Kaschierung allerdings analog der Proben 4a/4b vorgenommen, bleibt die sehr gute elektrische Leitfähigkeit auch nach Alterung unverändert erhalten (Proben 6a/6b).

Generell lassen sich also vorteilhafte Verbundgebilde dadurch erzeugen, dass oberflächenglatte Textilien wie Gewebe auf Basis von Polyestern, Polyamiden, Polyolefinen oder Baumwoll/Polyester oder Maschenware wie Interlock, Single-Jersey oder Maschenware mit eingelegten Futterfäden auf gleicher Materialbasis, insbesondere auch dann wenn diese textilen Flächengebilde zur Glättung mit erwärmten Walzen oder Platten kalandriert oder geprägt wurden, eingesetzt werden. Diese textilen Flächengebilde lassen sich dann idealerweise in einem Siebdruckverfahren, welches als Rolle zu Rolle-Verfahren oder mit Siebdrucktischen ausgeführt werden kann, mit elektrisch leitfähiger Masse bedrucken.

In einer zweiten Versuchsreihe wurde der Einfluss unterschiedlicher Vorbeschichtungen des Gewebes vor dem Aufbringen der Leitfähigkeitsschicht untersucht und die Leistungsaufnahme als Maß für die Leitfähigkeit unmittelbar nach der Herstellung und nach Wärmealterung bei 90 °C über 7 Tage ermittelt:

Hieraus ergibt sich, dass der negative Einfluss der Wärmealterung nur bei Aufbringung der Leitfähigkeitsbeschichtung auf ein unbeschichtetes Gewebe verhindert werden kann.

| Substrat | Leistungsaufnahme bei 2,8 V (DIN A5-Muster) ungealtert [Watt] | Leistungsaufnahme bei 2,8 V (DIN A5-Muster) nach 7 Tagen 120°C [Watt] |
|---|---|---|
| PES-Gewebe (47 g/m²) unbeschichtet, kalandriert | 69 | 69 |
| PES-Gewebe (47 g/m²) beschichtet mit Lösungsmittel-Polyurethanfilm (Impranil ELH A) | 104 | 93 |
| PES-Gewebe (47 g/m²) beschichtet mit Wasser-Dispersions-Polyurethanfilm (Impranil DLU) | 127 | 93 |
| PES-Gewebe (47 g/m²) beschichtet mit Wasser-Dispersions-Polyurethanfilm (Impranil 2077) | 117 | 91 |
| PES-Gewebe (47 g/m²) beschichtet mit Wasser-Dispersions-Polyurethanfilm (Impranil DLP) | 127 | 93 |
| PES-Gewebe (47 g/m²) beschichtet mit Polyurethanfilm auf Basis eines High-Solids mit MDI und PPG | 69 | 35 |
| PES-Gewebe (47 g/m²) beschichtet mit PVC-Film auf Basis S-PVC und C10/12-Phthalat | 116 | 93 |
| PES-Gewebe (47 g/m²) beschichtet mit PVC-Film auf Basis S-PVC und C10-Phthalat | 81 | 58 |

## Patentansprüche

1. Verfahren zur Herstellung eines flexiblen textilen elektrisch leitfähigen Flächenelements umfassend die folgenden Schritte:
a) Bereitstellen einer textilen Trägerschicht;
b) Aufbringen einer vernetzbaren wässrigen Polymerdispersion enthaltend elektrisch leitfähige Partikel auf die Oberfläche der textilen Trägerschicht und
c) Aushärten der Polymerdispersion zur Erzeugung einer elektrisch leitfähigen Schicht.
**dadurch gekennzeichnet, dass** wenigstens eine Hauptfläche der textilen Trägerschicht vor dem Aufbringen der vernetzbaren Polymerdispersion so geglättet wird, dass nach dem Glätten einen Sz-Wert von 1,0 mm oder weniger aufweist, bestimmt nach DIN EN ISO 25178-2:2012, vorzugsweise von 0,5 mm oder weniger, wobei die vernetzbare Polymerdispersion unmittelbar auf die geglättete Oberfläche der textilen Trägerschicht aufgebracht wird,
wobei das Glätten der wenigstens einen Hauptfläche der textilen Trägerschicht in einem Kalander unter Erwärmung erfolgt, wobei die Dicke der textilen Trägerschicht um wenigstens 40% verringert wird.

2. Verfahren nach Anspruch 1, **dadurch gekennzeichnet, dass** der Sz-Wert der textilen Trägerschicht beim Glätten auf 80% des Sz-Wertes vor dem Glätten verringert wird, bestimmt nach DIN EN ISO 25178-2:2012, vorzugsweise auf 60% oder weniger des Sz-Wertes vor dem Glätten.

3. Verfahren nach einem der vorstehenden Ansprüche, **dadurch gekennzeichnet, dass** die textile Trägerschicht ein Gelege, Gewirk, Gewebe oder einen Vlies umfasst oder daraus besteht, wobei die textile Trägerschicht insbesondere ein Gewebe umfasst oder daraus besteht.

4. Verfahren nach einem der vorstehenden Ansprüche, **dadurch gekennzeichnet, dass** die textile Trägerschicht ein Flächengewicht von 250 g/m² oder weniger aufweist, insbesondere von 20 bis 150 g/m², bevorzugt 40 bis 100 g/m².

5. Verfahren nach einem der vorstehenden Ansprüche, **dadurch gekennzeichnet, dass** die Aufbringung der vernetzbaren wässrigen Polymerdispersion enthaltend elektrisch leitfähige Partikel über ein Siebdruckverfahren erfolgt.

6. Verfahren nach einem der vorstehenden Ansprüche, **dadurch gekennzeichnet, dass** die vernetzbare wässrige Polymerdispersion ein Polyurethanpräpolymer enthält.

7. Verfahren nach einem der vorstehenden Ansprüche, **dadurch gekennzeichnet, dass** das Flächenelemente eine laterale spezifische Leitfähigkeit von wenigstens 0,5 S/cm aufweist, vorzugsweise wenigstens 2,0 S/cm.

8. Verfahren nach einem der vorstehenden Ansprüche, **dadurch gekennzeichnet, dass** das an der elektrisch leitfähigen Schicht ein oder mehrere elektrische Kontakte angebracht werden.

9. Verfahren nach einem der vorstehenden Ansprüche, **dadurch gekennzeichnet, dass** das Flächenelement auf einer oder beiden Hauptflächen mit wenigstens einer weiteren Schicht teilweise oder vollständig beschichtet ist, insbesondere mit einer Deckschicht, wobei die Deckschicht vorzugsweise eine Dekorschicht ist, die insbesondere als kompakte oder geschäumte Kunststoffschicht vorliegt und die auf ihrer Oberseite mit einer Prägung versehen ist, insbesondere mit einer Narbenprägung.

10. Verfahren nach Anspruch 9, **dadurch gekennzeichnet, dass** die weitere Schicht nicht als wasser- oder lösemittelbasierte Schicht aufgebracht wird.

11. Verfahren nach einem der vorstehenden Ansprüche, **dadurch gekennzeichnet, dass** das Aufbringen der vernetzbaren wässrigen Polymerdispersion enthaltend elektrisch leitfähige Partikel auf die geglättete Oberfläche der textilen Trägerschicht gemäß Schritt b) sowie optional das Aufbringen der wenigstens einen weiteren Schicht in einem Rolle-zu-Rolle Prozess erfolgt.

## Claims

1. Process for producing a flexible textile electrically conductive sheet element comprising the following steps:
a) providing a textile carrier layer;
b) applying a crosslinkable aqueous polymer dispersion containing electrically conductive particles to the surface of the textile carrier layer and
c) curing the polymer dispersion to produce an electrically conductive layer.
**characterized in that**, before the applying of the crosslinkable polymer dispersion, at least one main surface of the textile carrier layer is smoothed such that, after smoothing, it has an Sz value of 1.0 mm or less, determined according to DIN EN ISO 25178-2:2012, preferably of 0.5 mm or less, wherein the crosslinkable polymer dispersion is directly applied to the smoothed surface of the textile carrier layer,
wherein the smoothing of the at least one main surface of the textile carrier layer is carried out in a calender with heating, wherein the thickness of the textile carrier layer is reduced by at least 40%.

2. The process according to claim 1, **characterized in that**, during smoothing, the Sz value of the textile carrier layer is reduced to 80% of the Sz value before smoothing, determined according to DIN EN ISO 25178-2:2012, preferably to 60% or less of the Sz value before smoothing.

3. The process according to any of the preceding claims, **characterized in that** the textile carrier layer comprises or consists of a noncrimp fabric, knitted fabric, woven fabric or a nonwoven fabric, wherein the textile carrier layer in particular comprises or consists of a woven fabric.

4. The process according to any of the preceding claims, **characterized in that** the textile carrier layer has a basis weight of 250 g/m² or less, in particular from 20 to 150 g/m², preferably from 40 to 100 g/m².

5. Process according to any of the preceding claims, **characterized in that** the applying of the crosslinkable aqueous polymer dispersion containing electrically conductive particles is carried out via a screen printing process.

6. Process according to any of the preceding claims, **characterized in that** the crosslinkable aqueous polymer dispersion contains a polyurethane prepolymer.

7. The process according to any of the preceding claims, **characterized in that** the sheetlike elements have a lateral specific conductivity of at least 0.5 S/cm, preferably at least 2.0 S/cm.

8. The process according to any of the preceding claims, **characterized in that** one or more electrical contacts are attached to the electrically conductive layer.

9. The process according to any of the preceding claims, **characterized in that** the sheetlike element is, on one or both main surfaces, partially or completely coated with at least one further layer, in particular with an outer layer, wherein the outer layer preferably is a decorative layer which is in particular in the form of a compact or foamed plastic layer and is on its top side provided with an embossing, in particular with a grain embossing.

10. The process according to claim 9, **characterized in that** the further layer is not applied as a water- or solvent-based layer.

11. The process according to one of the preceding claims, **characterized in that** the applying of the crosslinkable aqueous polymer dispersion containing electrically conductive particles to the smoothed surface of the textile carrier layer according to step b) and optionally the applying of the at least one further layer is carried out in a roll-to-roll process.

## Revendications

1. Procédé de production d'un élément de surface textile flexible électriquement conducteur, le procédé comprenant les étapes suivantes :
a) fournir une couche de support textile ;
b) appliquer une dispersion aqueuse de polymère réticulable contenant des particules électriquement conductrices sur la surface de la couche de support textile et
c) faire durcir la dispersion de polymère pour produire une couche électriquement conductrice,
**caractérisé en ce qu'**au moins une surface principale de la couche de support textile est lissée avant l'application de la dispersion de polymère réticulable de façon à avoir, après le lissage, une valeur Sz de 1,0 mm ou moins, déterminée selon la norme DIN EN ISO 25178-2:2012, de préférence de 0,5 mm ou moins, la dispersion de polymère réticulable étant appliquée directement sur la surface lissée de la couche de support textile,
le lissage de l'au moins une surface principale de la couche de support textile étant effectué avec chauffage dans une calandre, l'épaisseur de la couche de support textile étant de préférence réduite d'au moins 40 %.

2. Procédé selon la revendication 1, **caractérisé en ce que** la valeur Sz de la couche de support textile lors du lissage est réduite à 80 % de la valeur Sz avant lissage, déterminée selon la norme DIN EN ISO 25178-2:2012, de préférence à 60 % ou moins de la valeur Sz avant le lissage.

3. Procédé selon l'une des revendications précédentes, **caractérisé en ce que** la couche de support textile comprend un canevas, un tricot, un tissé ou un non-tissé, ou est constituée de celui-ci, en particulier la couche de support textile comprenant un tissu ou étant constituée de celui-ci .

4. Procédé selon l'une des revendications précédentes, **caractérisé en ce que** la couche de support textile a un poids par unité de surface de 250 g/m² ou moins, en particulier de 20 à 150 g/m², de préférence de 40 à 100 g/m².

5. Procédé selon l'une des revendications précédentes, **caractérisé en ce que** l'application de la dispersion aqueuse de polymère réticulable contenant des particules électriquement conductrices est effectuée par un procédé de sérigraphie.

6. Procédé selon l'une des revendications précédentes, **caractérisé en ce que** la dispersion aqueuse de polymère réticulable contient un prépolymère polyuréthanne.

7. Procédé selon l'une des revendications précédentes, **caractérisé en ce que** l'élément de surface présente une conductivité spécifique latérale d'au moins 0,5 S/cm, de préférence d'au moins 2,0 S/cm.

8. Procédé selon l'une des revendications précédentes, **caractérisé en ce qu'**un ou plusieurs contacts électriques sont fixés sur la couche électriquement conductrice.

9. Procédé selon l'une des revendications précédentes, **caractérisé en ce que** l'élément de surface est partiellement ou totalement revêtu, sur une surface principale ou les deux, d'au moins une autre couche, notamment d'une couche de recouvrement, la couche de recouvrement étant de préférence une couche décorative qui se présente notamment sous la forme d'une couche matière synthétique compacte ou expansée et qui est pourvue sur sa face supérieure d'un gaufrage, en particulier d'un gaufrage grené.

10. Procédé selon la revendication 9, **caractérisé en ce que** l'autre couche n'est pas appliquée comme couche à base d'eau ou de solvant.

11. Procédé selon l'une des revendications précédentes, **caractérisé en ce que** l'application de la dispersion aqueuse de polymère réticulable contenant des particules électriquement conductrices sur la surface lissée de la couche de support textile selon l'étape b) et éventuellement l'application de l'au moins une autre couche sont effectuées selon un processus rouleau à rouleau (roll-to-roll processing) .
